Europäisches Patentamt

European Patent Office

Office européen des brevets

(19)

(11) **EP 0 702 452 A1**

(12) **EUROPEAN PATENT APPLICATION**

(43) Date of publication:
20.03.1996 Bulletin 1996/12

(51) Int Cl.[6]: **H03B 5/12**, H03D 3/24

(21) Application number: 95306240.3

(22) Date of filing: 05.09.1995

(84) Designated Contracting States:
**AT DE ES FR GB IT**

(30) Priority: **14.09.1994 GB 9418526**

(71) Applicant: **PLESSEY SEMICONDUCTORS LIMITED**
**Swindon, Wiltshire SN2 2QW (GB)**

(72) Inventors:
• **Moffat, Mark Alexander John**
**Swindon, Wiltshire SN1 3NY (GB)**
• **Cowley, Nicholas Paul**
**Wroughton, Wiltshire SN4 9HZ (GB)**

(74) Representative: **Hoste, Colin Francis**
**The General Electric Company p.l.c.**
**GEC Patent Department**
**Waterhouse Lane**
**Chelmsford, Essex CM1 2QX (GB)**

(54) **Voltage-controlled oscillator arrangement**

(57)     An oscillator arrangement which may be realised largely in integrated-circuit form, in which there is simulated a variable capacitor connected in parallel with an external LC tuned circuit to effect frequency variation of, say, ± 3% centred on 500 MHz in response to a control voltage variation, with 1% linearity.

The oscillator comprises two emitter coupled transistor pairs (Q3,Q4;Q5,Q6) and capacitors (C) for coupling the LC circuit to the coupled emitters of the pairs of transistors.

Figure 2 – VCO Schematic

## Description

This invention relates to voltage controlled oscillator arrangements.

Most conventional phase locked loop (PLL) FM demodulators employ an off-chip varactor tuned voltage controlled oscillator (VCO). There are considerable advantages to be gained from integrating this function, namely in the areas of external component count and application cost. The present invention provides a voltage controlled oscillator arrangement which can be realised to a greater extent in integrated form.

The proposed circuit arrangement effectively simulates the action of a variable capacitor which, when connected in parallel with an external LC tank, can be used to generate a variable frequency with a centre frequency defined by the tank operating frequency and a deviation of ±15MHz with 1% linearity defined by the on-chip control voltage.

According to a first aspect of the invention a voltage-controlled oscillator comprises a tuned circuit, amplifier means for sustaining oscillations in said tuned circuit, an emitter-coupled pair of transistors, capacitor means for applying a signal from said tuned circuit to the coupled emitters of said pair of transistors, and means for applying respective control signal voltages to the base electrodes of said pair of transistors, current signals from the collector circuit of one of said pair of transistors being summed with current signals from said amplifier means in a load resistor coupled to said tuned circuit.

According to a second aspect of the invention a voltage-controlled oscillator comprises an inductor/capacitor tuned circuit, amplifier means for sustaining oscillations in said tuned circuit, first and second transistors having their emitter electrodes connected together and to a first current source, third and fourth transistors having their emitter electrodes connected together and to a second current source, means coupling the base electrodes of the first and fourth transistors to a first input path, means coupling the base electrodes of the second and third transistors to a second input path, means connecting the collector electrodes of the first and third transistors to first load means of said amplifier means coupled to a first point in said tuned circuit, means connecting the collector electrodes of the second and fourth transistors to second load means of said amplifier means coupled to a second point in said tuned circuit, respective capacitor means connecting said first point in said tuned circuit to the emitter electrodes of said first and second transistors and the second point in said tuned circuit to the emitter electrodes of said third and fourth transistors, and means to apply a control signal voltage between said first and second input paths.

According to a third aspect of the invention a voltage-controlled oscillator comprises an inductor/capacitor tuned circuit, push-pull amplifier means for sustaining oscillations in said tuned circuit, said amplifier means including first and second load means between which said tuned circuit is coupled, first and second transistors having their emitter electrodes connected together and to a first current source, their collector electrodes connected respectively to said first and second load means and their base electrodes connected respectively to first and second circuit means for applying control signal voltages to said base electrodes, and first capacitor means arranged to conduct an oscillatory current by way of said first current source in dependence upon an oscillatory voltage developed across said first load means.

An embodiment of the invention will now be described by way of example with reference to the accompanying drawings, in which:

Figure 1 is a partially block schematic diagram of a voltage controlled oscillator arrangement in accordance with the present invention;

Figure 2 is a circuit diagram of the voltage controlled oscillator of Figure 1; and

Figure 3 is a circuit diagram of the sustaining amplifier of Figure 1.

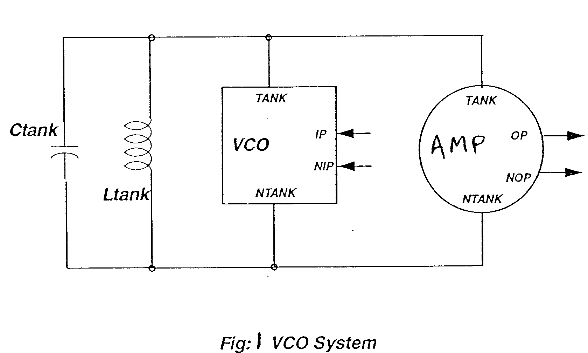

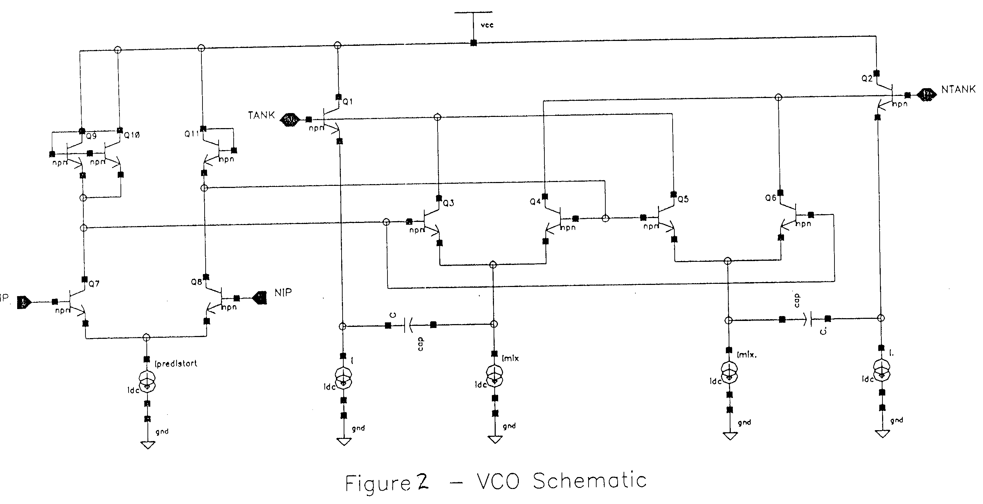

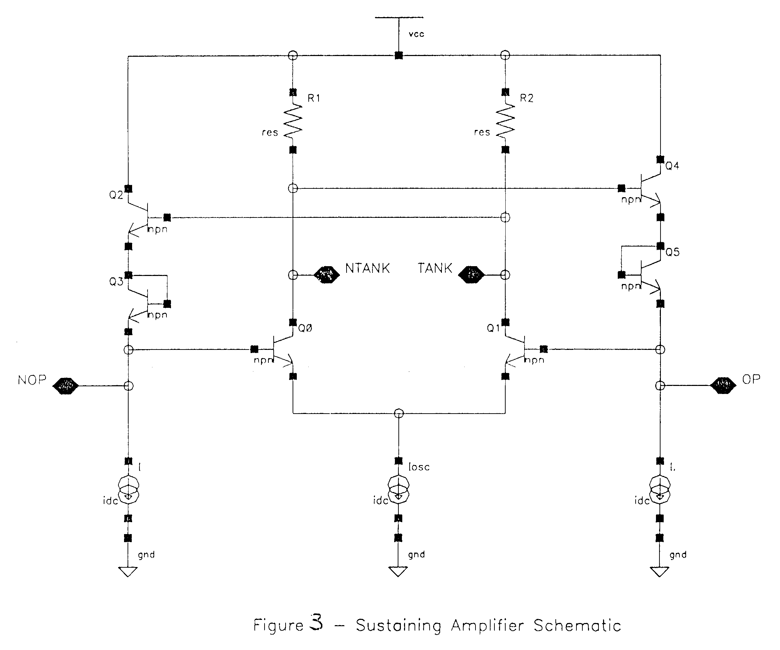

The voltage controlled oscillator arrangement shown in Figure 1 of the drawings comprises an external tank circuit consisting of a capacitor C tank and an inductor L tank connected in parallel, and connected to a voltage controlled oscillator circuit VCO and an oscillator sustaining amplifier AMP. The voltage controlled oscillator circuit VCO is shown in greater detail in Figure 2 and the oscillator sustaining amplifier AMP is shown in greater detail in Figure 3.

The technique proposed is to take the tank signal and shift it by ninety degrees using a small onchip capacitor. A varying proportion of this shifted signal is then added back to the tank signal to produce a frequency shift. This technique is fairly well known, but has only been used at low frequencies (<10 MHz). What is different about the proposed arrangement is that the circuit has a novel implementation that will allow it to run at frequencies of up to 1GHz.

In a conventional implementation of this technique the oscillator signal would by shifted by 90 degrees using an integrating capacitor and then added to the tank signal using a Gilbert cell. The problem with this is that at high frequencies the phase delay caused by the bottom pair of transistors in the Gilbert cell is significant, so a 90 degree shift is no longer obtained. By using the integrating capacitor C, to couple the signal directly onto the emitters of the top pairs (Q3, Q4, Q5, Q6) this problem is avoided. A proportion of this signal controlled by the top pairs is current-summed with the current in the sustaining amplifier at the sustaining amplifier load resistors.

The control signal is predistorted to maintain a linear relationship between V, the controlling voltage, and F, the oscillation frequency. The oscillation frequency of the circuit without predistortion is given by;

$$\omega = \frac{1}{\sqrt{Lt\left(Ct + 2\,C\tanh\left(\frac{V}{2\,Vt}\right)\right)}}$$

where;

ω =        oscillation frequency

Lt =       tank inductance

Ct =       tank capacitance

C =        coupling capacitor in VCO

V =        VCO input voltage

Vt =                                $\dfrac{Q}{kT}$

where

Q =                     Electron charge

k =                     Boltzman's constant

T =                     temperature (°K)

This will obviously not produce a linear dF/dV characteristic. The tanh term can be removed by applying a predistortion network to the control voltage, but the square root term is more complicated. By paralleling two diodes in the predistortion network and choosing current densities carefully it is possible to shift the predistortion characteristic such that a linear dF/dV can be produced over a small range. This makes this circuit unsuitable for designs where a wide tuning range is required, but performance is acceptable for this design where a shift of, say, 30MHz in 500MHz is required (i.e. 6%). The linearity of this oscillator has been simulated as 1% over this range.

It will be appreciated that the embodiment of the invention which has been described has been given by way of example only and may be adapted to suit any particular application. For example, although ideally suited for integrated circuit construction, conventional construction techniques may be used, and circuit details may be changed without changing the principle of operation.

## Claims

1. A voltage-controlled oscillator comprising a tuned circuit, amplifier means for sustaining oscillations in said tuned circuit, an emitter-coupled pair of transistors, capacitor means for applying a signal from said tuned circuit to the coupled emitters of said pair of transistors, and means for applying respective control signal voltages to the base electrodes of said pair of transistors, current signals from the collector circuit of one of said pair of transistors being summed with current signals from said amplifier means in a load resistor coupled to said tuned circuit.

2. A voltage-controlled oscillator comprising an inductor/capacitor tuned circuit, amplifier means for sustaining oscillations in said tuned circuit, first and second transistors having their emitter electrodes connected together and to a first current source, third and fourth transistors having their emitter electrodes connected together and to a second current source, means coupling the base electrodes of the first and fourth transistors to a first input path, means coupling the base electrodes of the second and third transistors to a second input path, means connecting the collector electrodes of the first and third transistors to first load means of said amplifier means coupled to a first point in said tuned circuit, means connecting the collector electrodes of the second and fourth transistors to second load means of said amplifier means coupled to a second point in said tuned circuit, respective capacitor means connecting said first point in said tuned circuit to the emitter electrodes of said first and second transistors and the second point in said tuned circuit to the emitter electrodes of said third and fourth transistors, and means to apply a control signal voltage between said first and second input paths.

3. A voltage-controlled oscillator comprising an inductor/capacitor tuned circuit, push-pull amplifier means for sustaining oscillations in said tuned circuit, said amplifier means including first and second load means between which said tuned circuit is coupled, first and second transistors having their emitter electrodes connected together and to a first current source, their collector electrodes connected respectively to first and second load means and their base electrodes connected respectively to first and second ciruit means for applying control signal voltages to said base electrodes, and first capacitor means arranged to conduct an oscillatory current by way of said first current source in dependence upon an oscillatory voltage developed across said first load means.

4. A voltage-controlled oscillator in accordance with Claim 3 including third and fourth transistors having their emitter electrodes connected together and to a second current source, their collector electrodes connected respectively to said first and second load means and their base electrodes connected respectively to said second and first circuit means, and second capacitor means arranged to conduct an oscillatory current by way of said second current source in dependence upon an oscillatory voltage developed across said second load means.

5. A voltage-controlled ocillator in accordance with Claim 3 or Claim 4 wherein said first and second circuit means comprise respective non-linear load means of a differential amplifier.

6. A voltage-controlled oscillator substantially as hereinbefore described with reference to the accompanying drawings.

Fig: 1 VCO System

Figure 2 – VCO Schematic

Figure 3 – Sustaining Amplifier Schematic

**European Patent Office**

**EUROPEAN SEARCH REPORT**

Application Number

EP 95 30 6240

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-5 187 450 (WAGNER GARY L ET AL) 16 February 1993<br>* column 3, line 1 - column 5, line 5; figure 1 * | 1-3 | H03B5/12<br>H03D3/24 |
| A | IEEE JOURNAL OF SOLID-STATE CIRCUITS, vol. 27, no. 3, 1 March 1992<br>pages 444-450, XP 000295903<br>NGUYEN N M ET AL 'A 1.8-GHZ MONOLITHIC LC VOLTAGE-CONTROLLED OSCILLATOR'<br>* page 444, column 1, paragraph 1 - paragraph 2; figure 1 * | 1-3 | |
| A | EP-A-0 412 435 (SGS THOMSON MICROELECTRONICS) 13 February 1991<br>* abstract; figure 4 * | 1-3 | |
| A | GB-A-2 043 378 (RCA CORP) 1 October 1980<br>* abstract; figure 1A * | 1-3 | |

TECHNICAL FIELDS SEARCHED (Int.Cl.6)

H03B
H03D

The present search report has been drawn up for all claims

| Place of search | Date of completion of the search | Examiner |
|---|---|---|
| THE HAGUE | 13 December 1995 | Dhondt, I |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)